# EUROPEAN PATENT SPECIFICATION

(11) **EP 3 537 478 B1**
(45) Date of publication and mention of the grant of the patent: **30.08.2023**
(21) Application number: 17835578.0
(22) Date of filing: 05.07.2017
(51) Int. Cl.: H10K 59/124, H10K 59/121, H10K 50/822, H10K 50/813, H10K 77/10

(54) **ORGANIC LIGHT-EMITTING DIODE DISPLAY PANEL AND FABRICATION METHOD THEREFOR**
ANZEIGETAFEL MIT ORGANISCHEN LEUCHTDIODEN UND HERSTELLUNGSVERFAHREN DAFÜR
PANNEAU D'AFFICHAGE À DIODE ÉLECTROLUMINESCENTE ORGANIQUE ET SON PROCÉDÉ DE FABRICATION

(30) Priority: 02.11.2016 CN 201610945114
(43) Date of publication of application: 11.09.2019
(73) Proprietor: BOE Technology Group Co., Ltd., Beijing 100015 (CN); Chengdu BOE Optoelectronics Technology Co., Ltd., Chengdu, Sichuan 611731 (CN)
(72) Inventor: LEE, Seungmin, Beijing 100176 (CN); ZHANG, Wenxuan, Beijing 100176 (CN); FAN, Zhenrui, Beijing 100176 (CN); XIONG, Li, Beijing 100176 (CN); LU, Zhong, Beijing 100176 (CN); YUAN, Hongguang, Beijing 100176 (CN); PARK, Beum Ku, Beijing 100176 (CN)
(74) Representative: Klunker IP Patentanwälte PartG mbB
(86) International application number: PCT/CN2017/091797
(87) International publication number: WO 2018/082328

(56) References cited:
- CN-A- 103 915 480
- CN-A- 105 405 394
- CN-A- 105 826 350
- US-A1- 2014 312 319
- US-A1- 2014 356 586
- US-A1- 2015 001 477

## Description

### TECHNICAL FIELD

The present invention relates to an organic light- emitting diode display panel and a manufacturing method thereof.

### BACKGROUND

A display which adopts an organic light-emitting diode (OLED) display panel has a wide application prospect because of following advantages: simple manufacturing process, fast response, thin, light, wide viewing angle, self-luminescent, high brightness, light emission color continuously adjustable, low power consumption, low cost, and easy to realize flexible display.

US 2014/312319 A discloses an OLED display. The OLED display includes a flexible substrate and a plurality of OLEDs. The flexible substrate includes at least one curved portion. The OLEDs are positioned in every pixel area that is set on the flexible substrate and includes a pixel electrode, an organic emission layer, and a common electrode. At least one OLED that is positioned at a curved portion in the OLEDs is formed in a lens shape and concentrates light toward the center of a pixel area.

US 2015/001477 A discloses an OLED display including a front display part including a plurality of front pixels formed on a substrate and realizing an image at a front and a side display part. A side pixel of the side display part includes: a plurality of thin film transistors formed on the substrate; a protective layer covering the plurality of thin film transistor and having an inclination groove that is oblique; a first electrode formed at the inclination groove of the protective layer; a pixel defining layer having an opening exposing the first electrode and formed on the protective layer; an organic emission layer formed on the first electrode and the pixel defining layer; and a second electrode covering the organic emission layer.

### SUMMARY

It is an object of the present invention to provide an OLED display panel and a manufacturing method thereof.

The object is achieved by the features of the respective independent claims.

Further embodiments are defined in the corresponding dependent claims. Even though the description refers to embodiments or to the invention, it is to be understood that the invention is defined by the claims and embodiments of the invention are those comprising at least all the features of one of the independent claims.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a schematic diagram illustrating viewing angle of a curved part of an organic light-emitting diode display panel;
FIG. 2 is a schematic structural diagram of an organic light-emitting diode display panel;
FIG. 3a is a schematic diagram illustrating viewing angle of a curved part of an organic light-emitting diode display panel not forming part of the invention;
FIG. 3b is a schematic diagram illustrating a structure of a part of an organic light-emitting diode display panel not forming part of the invention;
FIG. 3c is a schematic diagram illustrating a structure of a part of another organic light-emitting diode display panel not forming part of the invention;
FIG. 3d is a schematic diagram illustrating a structure of a part of another organic light-emitting diode display panel not forming part of the invention;
FIG. 4a is a schematic diagram illustrating viewing angle of a curved part of another organic light-emitting diode display panel according to the invention;
FIG. 4b is a schematic diagram illustrating a curve direction and a curve degree of the curved part and the organic light-emitting diode formed thereon of the organic light-emitting diode display panel as illustrated in FIG. 4a;
FIG. 5 is a schematic diagram of illustrating a structure of an organic light-emitting diode display panel not forming part of the invention;
FIG. 6 is a manufacturing method of an organic light-emitting diode display panel provided by an embodiment of the disclosure;
FIG. 7a is a schematic diagram illustrating a structure of a first electrode;
FIG. 7b is a schematic diagram of a mask plate;
FIG. 8a is a schematic view of forming a first electrode;
FIG. 8b is a cross-sectional diagram illustrating a structure of the first electrode taken along line A-B of FIG. 8a;
FIG. 9a is schematic diagram of forming a first electrode;
FIG. 9b is a cross-sectional view illustrating a structure of the first electrode taken along line C-D of FIG. 9a; and
FIG. 10 is a schematic diagram of forming a second curved surface of an upper surface of a planarization layer (a surface of the planarization layer away from a base substrate).

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the description and the claims of the present disclosure, are not intended to indicate any sequence, amount or importance, but distinguish various components. Also, the terms such as "a," "an," etc., are not intended to limit the amount, but indicate the existence of at least one. The terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

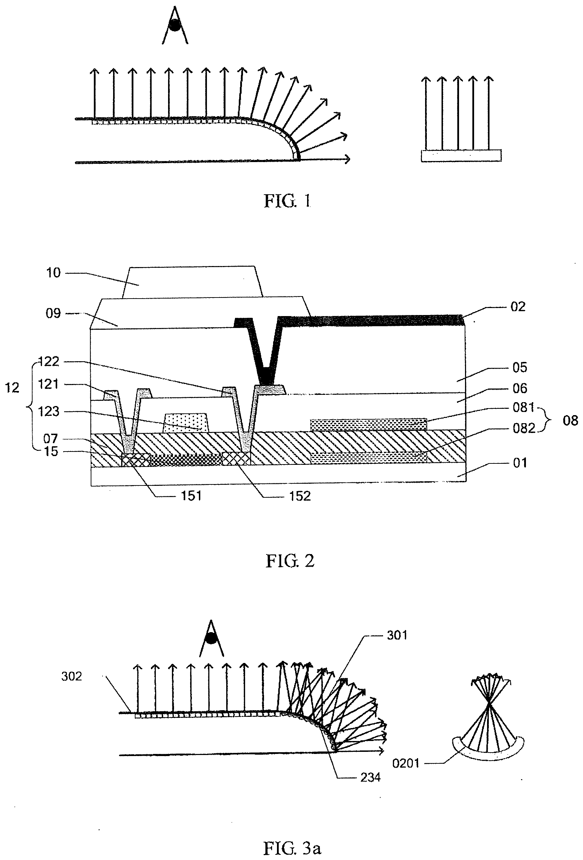

Generally, in order to improve the display effect, a light-exiting side of an OLED display panel is processed, so that most of the light generated from the OLED is emitted at a right angle of 90 degrees, therefore, a problem that a bad viewing angle (observation angle) of a curved part of the OLED display panel is produced. As illustrated in FIG. 1, because most of the light generated from the OLED on the curved part of the display panel is emitted at a right angle of 90 degrees, when viewing the display panel, human eyes receives less light from the curved part, resulting in darkening of an edge of the display panel and affecting display effect. Furthermore, the same problem occurs in actual mass production of the product.

Fig. 2 illustrates a structure of an OLED display panel. The OLED display panel includes a base substrate 01 and a function unit disposed on the base substrate 01. The function unit includes a thin film transistor 12 and a storage capacitor 08 which is electrically connected with the thin film transistor 12. For example, the base substrate 01 can be made of polyimide, and the thin film transistor 12 can be of a bottom-gate structure and can also be of a top-gate structure.

As illustrated in FIG. 2, when the thin film transistor 12 is of a top-gate structure, a gate insulation layer 07 is formed between a gate electrode 123 and an active layer 15 of the thin film transistor 12, and at the same time, the gate insulation layer 07 can also be disposed between an upper electrode 081 and a lower electrode 082 of the storage capacitor 08 to be served as a dielectric layer of the storage capacitor 08. A source electrode 121 and a drain electrode 122 are disposed on two sides of the active layer 15 respectively, and are electrically connected with the active layer 15. When the active layer adopts amorphous silicon, regions 151 and 152 where the active layer 15 is in contact with the source electrode and the drain electrode can form n⁺α-Si to form ohmic contact. It should be noted that, a material of the active layer is not limited to the amorphous silicon. Further, an interlayer insulation layer is formed between the gate electrode 123 and the drain electrode 122 of the thin film transistor 12, and a material of the interlayer insulation layer 06 can be silicon nitride or silicon oxide, but is not limited thereto.

The above-mentioned OLED display panel can further include a planarization layer 05 disposed on the interlayer insulation layer 06. A material of the planarization layer 05 can be an elastic organic material, for example, polyimide. A structure of the OLED display panel further includes a first electrode 05 of the OLED disposed on the planarization layer 05 and a pixel definition layer 09, and the pixel definition layer 09 is configured to define a sub-pixel region. The OLED can includes a plurality of layers, the first electrode 02 can be a layer of the OLED, and other layers of the OLED formed on the first electrode 02 are not illustrated herein. The OLED display panel can further include a supporting layer 10. The first electrode 02 of the OLED of a general OLED display panel is flat relative to the base substrate 01 (after the OLED display panel is bent, the first electrode 02 may have the same curve direction and the same curvature as the base substrate of the curved part), and the curved part of the OLED display panel in a state of the first electrode 02 being flat relative to the base substrate 01 limits the viewing angle. Because most of the light generated from the OLEDs on the curved part is emitted at a right angle of 90 degrees, when viewing the display pannel, human eyes receive less light generated from the curved part, thereby resulting in darkening of an edge of the display panel, and affecting display effect.

At least one embodiment of the disclosure provides an OLED display panel, including a curved part and a non-curved part. The curved part includes a plurality of OLEDs, each of the OLEDs includes a light adjusting surface, and the light adjusting surface is configured to be capable of guiding light generated from the OLED to exit towards the non-curved part. A convex side of the curved part is a light-exiting side, for example, the convex side of the curved part refers to a surface of the curved part which arches up, which is said relative to a surface of the curved part which is recessed. The curved part includes a base substrate and a plurality of OLEDs disposed on the base substrate, each of the OLEDs includes a light adjusting surface, and the light adjusting surface is configured to be capable of guiding light generated from the OLED to exit toward the non-curved part. For example, the OLED on the curved part has a divergent light-emitting angle. For example, the OLED has a plurality of layers, the plurality of layers includes a luminescent layer, the luminescent layer or a layer formed after the luminescent layer has a first curved surface. On the curved part, a curve direction of the first curved surface is the same as that of the base substrate, and a curvature of the first curved surface is larger than that of the base substrate. For example, the light adjusting surface can include the first curved surface. The first curved surface can enable most of the light generated from the OLED (for example, one OLED can correspond to one sub-pixel) to emit no longer at a right angle of 90 degrees, but to emit to various angles, to form divergent light. so that the light-emitting angle is divergent, and the sub-pixel to which the OLED belongs can be seen at different viewing angles, which can improve or avoid the phenomenon that the edge of the display panel is darkened, improve the viewing angle and improve the display quality. For example, in the OLED display panel provided by at least one embodiment of the disclosure, the light-emitting angle of the OLED is larger than 90°, for further example, the light-emitting angle can reach 150°. For example, a light-emitting angle of the OLED can be in a range from 30° to 150°. The light-emitting angle refers to an included angle between the light generated from the OLED and the base substrate on which the OLED is disposed, for example.

At least one embodiment of the disclosure further provides a manufacturing method of an OLED display panel, including: forming a first layer of an OLED on a part of a base substrate of the OLED display panel to be bent, a surface of the first layer away from the base substrate having a curved surface; forming a subsequent film layer of the OLED on the first layer, the subsequent film layer having the curved surface and including a luminescent layer; bending the OLED display panel to form a curved part, the OLED on the curved part including a light adjusting surface, and the light adjusting surface being configured to be capable of guiding light generated from the OLED to exit towards a non-curved part. A convex side of the curved part is a light-exiting side, and the OLED on the curved part has a divergent light-emitting angle. The luminescent layer on the curved part has a first curved surface. On the curved part, a curve direction of the first curved surface is the same as that of the base substrate, and a curvature of the first curved surface is larger than that of the base substrate. Thus, the OLED display panel manufactured can be made to have a divergent light-emitting angle, and the display panel can be viewed from different angles, so as to improve viewing angle. The OLED display panel before being bent is in a flat state, the curved surface of the OLED before being bent is generally different from the first curved surface of the OLED after being bent, and a curvature of the curved surface of the OLED after being bent is slightly changed from a curvature of the first curved surface of the OLED before being bent.

The OLED display may be fabricated using a mask plate, including a first portion and a second portion. The second portion is disposed at a periphery of the first portion, the second portion includes a plurality of sub-portions arranged in sequence in a direction from a position close to the first portion to a position away from the first portion, optical transmittances of the plurality of the sub-portions are decreased in sequence in the direction from the position close to the first portion to the position away from the first portion, and an optical transmittance of the first portion is larger than that of each of the sub-portions, or, optical transmittances of the plurality of the sub-portions are increased in sequence in the direction from the position close to the first portion to the position away from the first portion, and an optical transmittance of the first portion is smaller than that of each of the sub-portions. The light transmitted through the mask plate forms different levels of illuminance, and thus an upper surface of a film layer manufactured by the mask plate can form a curved surface/a curved surface shape, for example, form a concave shape or a convex shape.

First example useful for understanding the invention

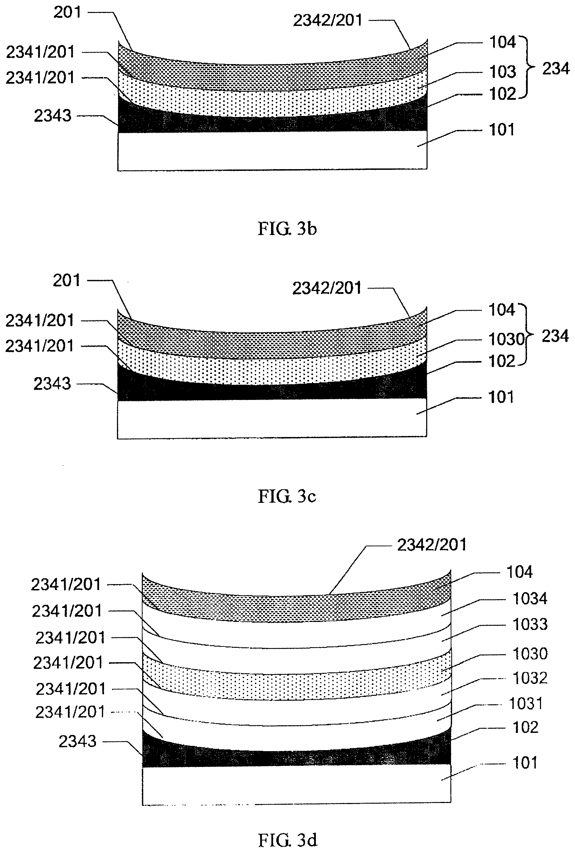

The example provides an OLED display panel, as illustrated in FIG. 3a. The OLED display panel includes a curved part 301, and a convex side of the curved part 301 is a light-exiting side. As illustrated in FIGS. 3a and 3b, the curved part 301 includes a base substrate 101 and a plurality of OLEDs 234 disposed on the base substrate 101, and FIG 3b illustrates one of the OLEDs 234 on the curved part 301. The OLED 234 includes a plurality of layers, and an interface 2341 between any two adjacent layers of the OLED and a surface 2342 of the OLED away from the base substrate 101 have a first curved surface 201. For example, a luminescent layer or a layer formed after the luminescent layer has the first curved surface. The first curved surface 201 is employed to guide the OLED to exit divergent light having different angles, so that the light-emitting angle is divergent, and the sub-pixel to which the OLED belongs can be seen at different viewing angles, to improve the viewing angle.

For example, as illustrated in FIG 3b, in the plurality of layers disposed on the base substrate 101, a layer close to the base substrate 101 is a first electrode 102, a layer away from the base substrate 101 is a second electrode 104, and the OLED further includes a function layer 103 disposed between the first electrode 102 and the second electrode 104. An interface between any two adjacent layers of the OLED has a first curved surface 201, that is, an interface between the first electrode 102 and the function layer 103 and an interface between the function layer 103 and the second electrode 104 have the first curved surface 201. When the function layer 103 includes a plurality of layers, an interface between any two adjacent layers of the function layer has the first curved surface 201.

For example, the function layer 103 of the OLED at least includes a luminescent layer 1030. In one example, as illustrated in FIG. 3c, the function layer 103 of the OLED includes a luminescent layer 1030. The function layer 103 of the OLED can include at least one selected from the group consisting of a hole transport layer, a hole injection layer, a hole blocking layer, an electron transport layer, an electron injection layer, and an electron blocking layer, in addition to the luminescent layer 1030. In another example, as illustrated in FIG. 3d, the function layer 103 further includes a hole injection layer 1031, a hole transport layer 1032, an electron transport layer 1033, and an electron injection layer 1034. The hole blocking layer and the electron blocking layer are not illustrated in figures, and can be disposed by referring to a conventional design. For example, the hole blocking layer can be disposed between the electron transport layer and the luminescent layer, and the electron blocking layer can be disposed between the hole transport layer and the light-emitting layer, but is not limited thereto. Materials of respective layers of the OLED can refer to a convention design.

As illustrated in FIG. 3d, the interface between any two adjacent layers of the function layer has the first curved surface 201, and because a surface of the first electrode 102 away from the base substrate 101 has the first curved surface 201, a subsequent layer formed on the first electrode 102 conforms the topography of the surface of the first electrode away from the base substrate 101. Thus, the interface between any two adjacent layers of the OLED and the surface of the OLED away from the base substrate (an upper surface of a layer of the OLED away from the base substrate 101) are made to have the first curved surface 201.

As illustrated in FIGS. 3b-3d, in the OLED, the interface between any two adjacent layers and the surface of the layer away from the base substrate 101 have the same curve direction and the same curvature.

It should be noted that, in the OLED, the luminescent layer 1030 has the first curved surface 201 to make the light-emitting angle be divergent. The luminescent layer 1030 having the first curved surface 201 refers to both of the surface of the luminescent layer 1030 close to the light-exiting side and the surface of the luminescent layer 1030 away from the light-exiting side having the first curved surface 201, and the two surfaces being bent towards the same direction. That is, a layer having a curved surface refers to both of surfaces of the layer close to the light-exiting side and away from the light-exiting side having the curved surface and the two surfaces being bent towards the same direction. In one example, a layer of the OLED formed after the luminescent layer has the first curved surface 201. In another example, respective layers of the OLED have the first curved surface 201. As illustrated in right side of FIG. 3a, the OLED having the first curved surface which is disposed on the curved part 301 emits light towards various directions, to form divergent light. When viewing the display panel, human eyes receive more light generated from the curved part, which improves the viewing angle, realizes a better display effect and avoids the phenomenon of the edge darkening of the display panel.

For example, same or opposite curve directions are described relative to the light-exiting side. The curve directions of two structures only can be the same or opposite. If both of a curve direction of one structure and a curve direction of the other structure are towards the light-exiting side (or the light-exiting direction), the curve directions of the two structures are the same. If a curve direction of one structure is towards the light-exiting direction and a curve direction of the other structure is away from the light-exiting side, the curve directions of the two structures are opposite. One curved structure being towards the light-exiting side refers to a side of the structure which is recessed being towards the light-exiting side. Herein, the curved structure is not required to directly face the light-exiting side, and it can deviate an angle from the light-exiting side. As illustrated in FIG. 3a, the OLED having the first curved surface on the curved part 301 is towards the light-exiting side, and the base substrate of the curved part is away from the light-exiting side. The above-mentioned structure refers to a layer or a curved surface, for example.

For example, the base substrate 101 can be made of at least one selecting from the group consisting of polyimide, polycarbonate, polyacrylate, polyetherimide, polyethersulfone, polyethylene terephthalate, and polyethylene naphthalate. The first electrode 102 can be made of a transparent conductive material having high work function. For example, the first electrode 102 can be formed by indium zinc oxide, indium tin oxide, indium tin zinc oxide, zinc oxide or tin oxide. The second electrode 104 can be formed by a material having high conductivity and low work function. For example, the second electrode 104 can be made of a metal material. The above-mentioned are listed materials of respective layers, but the materials of respective layers are not limited by the embodiment. For example, the first electrode 102 can be made of a metal material. The second electrode 104 can adopt a transparent electrode or a semi-transparent electrode, for example, the second electrode 104 can be formed by a metal, and can also be formed by a conductive oxide material, such as indium zinc oxide, indium tin oxide, indium tin zinc oxide, zinc oxide or tin oxide. For example, the first electrode 102 is an anode, and the second electrode 104 is a cathode. Holes provided by the anode and electrons provided by the cathode can be combined in the luminescent layer 1030 to emit light. For example, appropriate materials for respective layers can be selected, to form a flexible display panel.

In FIG. 3a, the OLED having the first curved surface 201 is disposed on the curved part is illustrated as an example. It should be noted that, the OLED having the first curved surface 201 can also be disposed on the non-curved part, or the OLEDs having the first curved surface 201 can be disposed on both of the curved part and the non-curved part. The curved part 301 and the non-curved part 302 of FIG. 3a are of an integral structure, and the curved part 301 is obtained by being bent. For example, the curved part is at least a portion of the OLED display panel close to an edge of the OLED display panel. For example, at least one side of the OLED display panel close to an edge of the OLED display panel can have the curved structure, but is not limited thereto.

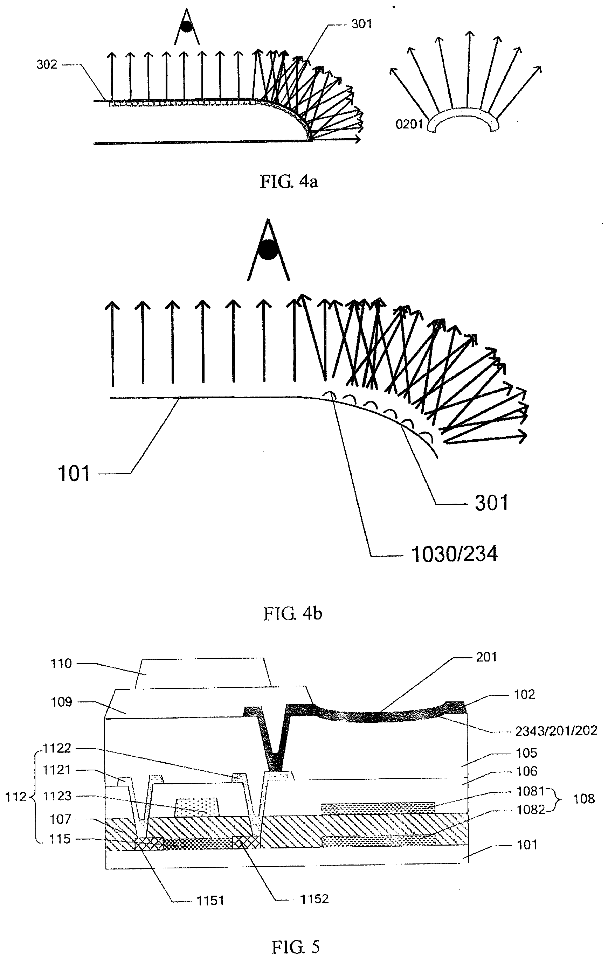

For example, as illustrated in FIG. 3a, a curve direction of the first curved surface 201 of the OLED disposed on the curved part 301 is opposite to that of the curved part 301. In the embodiment of the invention illustrated in FIG. 4a, a curve direction of the first curved surface 201 of the OLED disposed on the curved part 301 can also be the same as that of the curved part 301. In this case, a curvature of the curved part 301 (the base substrate 101.) is different from that of the first curved surface 201 of the OLED disposed on the curved part 301. For example, in order to allow more light to enter human eyes, a curvature of the first curved surface 201 of the OLED disposed on the curved part 301 can be made larger than that of the curved part 301. As illustrated in FIG. 4b, the luminescent layer 1030 having the first curved surface on the curved part 301 is away from the light-exiting side, and the base substrate of the curved part is also away from the light-exiting side. In FIG. 4b, an example in which the luminescent layer 1030 of the OLED on the curved part 301 has the first curved surface is illustrated for description. In the case that the curved part and the OLED having the first curved surface have the same curve direction, respective layers of the OLED can be disposed by referring to the case that the curved part and the OLED having the first curved surface have opposite curve directions, which is not repeated herein. For example, in order to avoid edge darkening better, a ratio of an absolute value of a difference between the curvature of the first curved surface and the curvature of the base substrate to the curvature of the first curved surface can be 20%-50%, and for further example, the ratio can be 25%-40%, but is not limited thereto.

For example, as illustrated in FIGs 3a and 4a, the first curved surface 201 can be a light adjusting surface 0201, and the light adjusting surface 0201 is configured to be capable of guiding light generated from the OLED 234 to exit towards the non-curved part 302.

Second example useful for understanding the invention

The example provides an OLED display panel, and as illustrated in FIG. 5, the OLED display panel includes a base substrate 101 and a function unit disposed on the base substrate 101. The function unit includes a thin film transistor 112 and a storage capacitor 108 electrically connected with the thin film transistor 112. An active layer 115 is formed on the base substrate 101, and the active layer 115 includes a channel region, a source electrode contact region 1151 electrically connected with the source electrode and a drain electrode contact region 1152 electrically connected with the drain electrode. The source electrode contact region 1151 and the drain electrode contact region 1152 of the active layer 115 are electrically connected with the source electrode 1121 and the drain electrode 1122 respectively. For example, the active layer 115 can adopt amorphous silicon (α-Si), and the source electrode contact region 1151 and the drain electrode contact region 1152 can be n⁺α-Si. but are not limited thereto. For example, the active layer 115 can also adopt other materials, for example, oxide semiconductor etc.. If the thin film transistor 112 is turned on, an electric current of the source electrode is conducted to the first electrode 102 (for example, the anode) of the OLED through the drain electrode.

The thin film transistor 112 can be of a bottom-gate structure and can also be of a top-gate structure. As illustrated in FIG. 5, in the case that the thin film transistor 112 is of the top-gate structure, a gate insulation layer 107 is formed between a gate electrode 1123 and the active layer 115 of the thin film transistor 12, and at the same time, the gate insulation layer 107 can also be disposed between an upper electrode 1081 and a lower electrode 1082 of the storage capacitor 108 so as to be served as a dielectric layer of the storage capacitor 108. Further, an interlayer insulation layer 106 is formed between the gate electrode 1123 and the drain electrode 1122 of the thin film transistor 112. For example, a material of the interlayer insulation layer 107 can be silicon nitride, silicon oxide or a combination thereof, but is not limited thereto. For example, the interlayer insulation layer 106 can be formed by the same material as the gate insulation layer 107, and can also be formed by other materials, and limitations are not imposed thereto.

For example, a surface 2343 of the OLED close to the base substrate 101 has a first curved surface 201. Thus, a layer (for example, an anode) of the OLED close to the base substrate 101 has a first curved surface 201. For example, the first curved surface 201 can be a light adjusting surface 0201 (as illustrated in FIGS. 3a and 4a), and the light adjusting surface 0201 is configured to be capable of guiding light generated from the OLED 234 to exit towards a non-curved part 302.

For example, the OLED display panel further includes a planarization layer 105 disposed between the base substrate 101 and a layer of the OLED close to the base substrate 101, the layer of the OLED close to the base substrate 101 is in contact with the planarization layer 105, a surface of the planarization layer 105 away from the base substrate 101 has a second curved surface 202, and the second curved surface 202 and the first curved surface 201 have the same curve direction and the same curvature. The second curved surface 202 coincides with the first curved surface 201. For example, a material of the planarization layer 105 can include polyimide, but is not limited thereto.

The OLED display panel can further include a pixel definition layer 09 and a first electrode 102 of the OLED disposed on the planarization layer 105, and the pixel definition layer 109 is configured to define a region of a sub-pixel. The first electrode 102 is a layer of the OLED, and other layers of the OLED are not illustrated herein. The OLED display panel can further include a supporting layer 10 disposed on the pixel definition layer 109.

Both of an upper surface and a lower surface of the first electrode 102 of the OLED display panel are curved surfaces, and the two surfaces has the same curve direction and the same curvature, so that a subsequent film layer of the OLED also forms a structure in which an upper surface and a lower surface of the subsequent film layer are curved surfaces, so as to make the light generated from the OLED being divergent, to improve the viewing angle.

For example, a material of a source electrode 1121, a drain electrode 1122 and a gate electrode 1123 of the thin film transistor 112 can include one or more of molybdenum, titanium, aluminum, and copper etc., but is not limited thereto.

Method of manufacturing an OLED display according to the invention

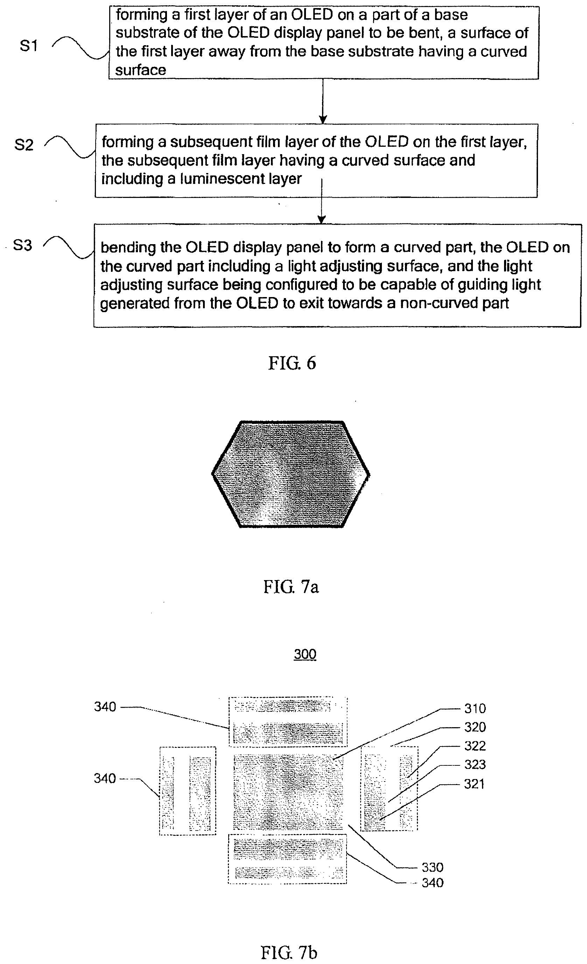

As illustrated in FIG. 6, the embodiment provides a manufacturing method of an OLED display panel, including following steps.

S1: forming a first layer of an OLED on a part of a base substrate of the OLED display panel to be bent, a surface of the first layer away from the base substrate having a curved surface;

S2: forming a subsequent film layer of the OLED on the first layer, the subsequent film layer having a curved surface and including a luminescent layer;

S3: bending the OLED display panel to form a curved part, the OLED on the curved part including a light adjusting surface 0201 (referring to FIGS. 3a and 4a), and the light adjusting surface being configured to be capable of guiding light generated from the OLED to exit towards a non-curved part. The light adjusting surface includes a first curved surface. A convex side of the curved part is a light-exiting side; a luminescent layer on the curved part has the first curved surface; on the curved part, a curve direction of the first curved surface is the same as that of the base substrate, and a curvature of the first curved surface is larger than that of the base substrate.

Thus, most of the light generated from the OLED is no longer emitted at a right angle of 90 degrees, and the OLED emits divergent light having different angles. When viewing the display panel, human eyes receives more light emitted from the curved part, thereby realizing a better display effect and avoiding the phenomenon of edge darkening.

For example, as illustrated in FIG. 3a, the OLED having the first curved surface is disposed on the curved part 301. Of course, the OLED having the first curved surface can also be disposed on the non-curved part 302, or the OLEDs having the first curved surface 201 can be disposed on both of the curved part 301 and the non-curved part 302.

For example, as illustrated in FIG. 3a, in one example not forming part of the invention, a curve direction of the curved part is different from that of the first curved surface of the OLED disposed on the curved part, for example, the curve directions are opposite.

For example, in the manufacturing method of the OLED display panel, a surface of the first layer of the OLED close to the base substrate has the first curved surface. For example, an upper surface of a layer below the OLED and in contact with the OLED can be made to form a curved surface, so that both of a lower surface and an upper surface of the first layer of the OLED have curved surfaces.

For example, as illustrated in FIG. 5, in one example not forming part of the invention, the manufacturing method of the OLED display panel further includes forming a planarization layer between the base substrate and the layer of the OLED close to the base substrate, the layer of the OLED close to the base substrate is in contact with the planarization layer, a surface of the planarization layer away from the base substrate has a second curved surface, and the second curved surface and the first curved surface have the same curve direction and the same curvature. Thus, the surface of the planarization layer away from the base substrate is better attached to the surface of the first layer of the OLED close to the base substrate, and the surface of the first layer of the OLED close to the base substrate has the first curved surface. The first curved surface can coincide with the second curved surface. The first layer of the OLED is formed on the surface of the planarization layer away from the base substrate, the surface of the first layer away from the base substrate has the first curved surface, and the first curved surface and the second curved surface can have the same curve direction and the same curvature. Therefore, the OLED can emit divergent light having different angles, which can improve the viewing angle. The method provided by the example is simply and easy to apply.

For example, the planarization layer having the second curved surface can be formed by adopting a multi-tone mask plate.

FIG. 7a is a schematic diagram illustrating a structure of a first electrode, and FIG. 7b is a schematic diagram of a mask plate. As illustrated in FIG. 7b, the mask plate 300 includes: a first portion 310 and a second portion 320. The second portion 320 is disposed at a periphery of the first portion 310 and a first spacing 330 is disposed between the first portion 310 and the second portion 320. The second portion 320 includes a plurality of sub-portions 321 and 322 arranged in sequence in a direction from a position close to the first portion 310 to a position away from the first portion 310, a second spacing 323 is disposed between any two adjacent sub-portions 321 and 322, and in the direction from the position close to the first portion 310 to the position away from the first portion 310, optical transmittances of the plurality of the sub-portions 321 and 322 are decreased in sequence, and the optical transmittance of the first portion 310 is larger than that of each of the sub-portions 321 and 322. In FIG. 7b, an example in which the second portion 320 includes two sub-portions 321 and 322 is illustrated for description, and a number of the sub-portions included in the second portion 320 is not limited as illustrated in figures. Thus, a curved surface having a concave upper surface can be formed.

For example, an area of the first portion 310 is larger than an area of each of the sub-portions 321 and 322. For example, a shape of the first portion 310 includes any one of a polygon and a circle.

For example, an area of the first spacing 330 is larger than that of each of the second spacings 323.

For example, in the direction from the position close to the first portion to the position away from the first portion, areas of respective second spacings 323 are equal to each other or are decreased in sequence. That is, the second portion 320 includes at least one spacing, and the areas of respective spacings are equal to each other or are decreased in sequence.

For example, in one example, optical transmittance of the first portion 310 is the largest, optical transmittances of respective sub-portions 321 and 322 of the second portion 320 are decreased in sequence in the direction from the position close to the first portion 310 to the position away from the first portion 310, and the optical transmittances of the first spacing 330 and the second spacing 323 are 0% (opaque).

For example, the optical transmittance of the first portion 310 is 80%-90%, the optical transmittance of the sub-portion 321 of the second portion 320 is 70%-80%, the optical transmittance of the sub-portion 322 of the second portion 320 is 60%-70%, and the optical transmittances of the first spacing 330 and the second spacing 323 are 0% (opaque).

The example in which the first spacing is disposed between the second portion 320 and the first portion 310 and the second spacing is disposed between any two adjacent sub-portions is illustrated above for description, but the first spacing and/or the second spacing may not be provided, so that the first portion and the second portion are abutted, any two adjacent sub-portions of the second portion are abutted, and in a direction from the first portion 310 to the second portion 320, the optical transmittances of the first portion and the respective sub-portions are decreased in sequence. The optical transmittances of the first spacing and the second spacing can also be adjusted, so that in the direction from the first portion 310 to the second portion 320, the optical transmittances are decreased in sequence. For example, in one example, in the direction from the first portion 310 to the first spacing 330 and further to the second portion 320, the optical transmittances are decreased in sequence. That is, the optical transmittances of the first portion 310, the first spacing 330, and the second portion 320 are decreased in sequence. Further, in the second portion 320, in the direction from the position close to the first portion 310 to the position away from the first portion 310, the optical transmittances are decreased in sequence. For example, the optical transmittances of the sub-portion 321, the second spacing 323 and the sub-portion 322 are decreased in sequence. Further, the optical transmittances of the first portion 310, the first spacing 330, the sub-portion 321, the second spacing 323 and the sub-portion 322 are decreased in sequence. Thus, the mask plate can be used to manufacture an upper surface of the curved/concave-shaped surface. For example, the mask plate can be used to form a planarization layer with a concave-shaped upper surface.

For example, in one example, the second portion 320 is disposed on a side of the first portion 310, the mask plate further includes at least one third portion 340 having the same structure and the same arrangement as the second portion 320, and each third portion 340 is not overlapped with the second portion 320. As illustrated in FIG. 7b, the third portion 340 and the second portion 320 have the same structure and the same arrangement, and the example illustrates that the third portions 340 are distributed in three directions except a direction in which the second portion is positioned. Of course, a number of the third portions are not limited as illustrated in figures, and it can be other numbers. For example, the second portion 320 can also be disposed to surround the first portion 310 to form a closed structure. For example, a plurality of concentric ring structures can be formed around the first portion from inside to outside, for example, concentric circle rings and concentric polygon rings etc. can be formed.

In the case that the planarization layer 105 adopts a photoresist material, a curved surface structure can be formed on an upper surface of the planarization layer 105 after exposure and development by adopting any one of the mask plates . On this basis, the OLED having the first curvature can be manufactured.

The above listed mask plates can form a layer having a concave shape. Furthermore, according to process requirements, widths of the first portion 310, the second portion 320, the first spacing 330 and the second spacing 323 can be freely adjusted, to form the concave shape as required by the process.

For example, a layer having a convex shape can be formed by designing the mask plate. In another example, in the direction from the position close to the first portion 310 to the position away from the first portion 310, the optical transmittances of the plurality of the sub-portions are increased in sequence, and the optical transmittance of the first portion is smaller than that of each of the sub-portions. Thus, a curved surface having a convex-shaped upper surface can be formed. For example, the mask plate can be used to form a planarization layer having a convex-shaped upper surface. For example, according to process requirements, widths of the first portion 310, the second portion 320, the first spacing 330 and the second spacing 323 can be freely adjusted, to form the convex shape as required by the process.

Any mask plate can be used to manufacture the OLED display panel described in the foregoing sections.

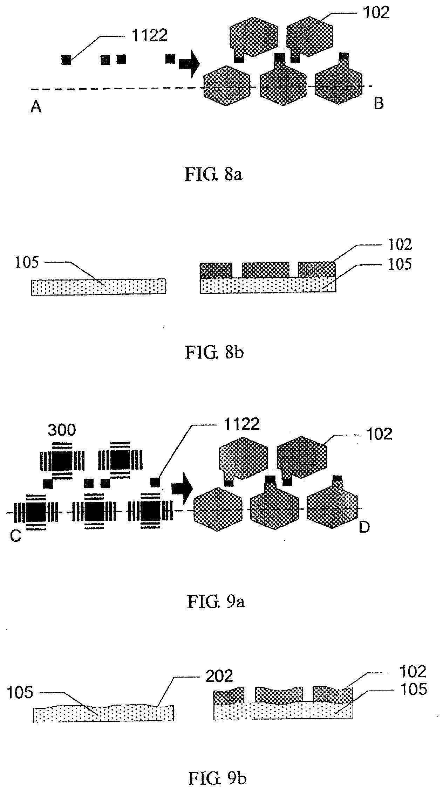

FIG. 8a is a schematic diagram of forming a first electrode, and FIG. 8b is a cross-sectional view illustrating a structure of the first electrode taken along line A-B of FIG. 8a. Generally, a structure of the first electrode 102 as illustrated in FIG. 8a is formed on the planarization layer 105, and both of the planarization layer 105 and the first electrode 102 formed herein are flat structures. In a state of the flat structure, a curved part of the OLED display panel limits the viewing angle, and most of the light generated from the OLED formed on the curved part is emitted at a right angle of 90 degrees, so that when human eyes views the display panel, light emitting from the curved part is less received, thereby affecting the display effect, and producing a phenomenon of edge darkening.

FIG. 9a is a schematic diagram of forming a first electrode and FIG. 9b is a cross-sectional view illustrating a structure of the first electrode taken along line C-D of FIG. 9a As illustrated in FIG. 9a, a second curved surface is formed on a surface (an upper surface) of the planarization 105 away from the base substrate by using any one of the mask plates to form a concave shape layer and then the first electrode 102 is formed on the second curved surface. A first curved surface is formed on a surface of the first electrode 102 close to the planarization layer 15 having the same curve direction and the same curvature as the second curved surface, and the first curved surface is formed on an surface of the first electrode 102 away from the planarization layer 105. Further, a subsequent film layer of the OLED is formed. The first curved surface is formed so that most of the light generated from the OLED is no longer emitted at a right angle of 90 degrees, and the OLED emits divergent light having different angles, so as to improve the viewing angle.

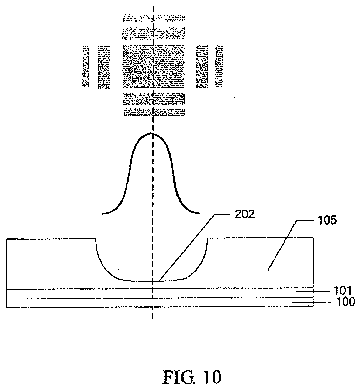

For example, FIG. 10 is a schematic diagram of forming a second curved surface . As illustrated in FIG. 10, the mask plate can be used by adjusting the optical transmittances to obtain that the first portion and the second portion have different optical transmittances and the optical transmittance of the first portion is larger than that of the second portion, so that different levels of illuminance can be formed on the planarization layer 105. With this mask plate, the flat portion of the planarization layer 105 can be formed into a curved structure by photolithography, that is, a second curved surface is formed on a surface of the planarization layer 105 away from the base substrate, without adding any process. In this case, a material of the planarization layer 105 can be a photoresist, and for example, the material of the planarization layer 105 can include polyimide, but is not limited thereto. Then, the first electrode 102 is formed on the second curved surface, and the first curved surface having the same curve direction and the same curvature as the second curved surface is formed on a surface of the first electrode 102 away from the planarization layer 105.

Thus, in subsequent film layers of the OLED, an interface between any two adjacent layers and a surface of a layer away from the base substrate 101 have the first curved surface 201, and the formed curved OLED can form divergent light emitting to various angles, so as to improve the viewing angle. In a case that the OLED having the first curved surface 201 is disposed on the curved part, when viewing the display panel, human eyes receives more light emitting from the curved part, thereby realizing a better display effect.

Of course, the first curved surface can be formed on the upper surface of the first electrode by adopting other methods. For example, the first electrode is etched, so that a structure of a curved surface is formed on the upper surface of the first electrode. The method of forming the curved surface is not limited by the embodiments of the disclosure.

FIG. 10 further illustrates a base 100, and when a flexible display panel is manufactured, the base substrate 104 of the flexible display panel can be placed on the base 100 to manufacture. The base 100 is removed after completing the manufacturing. Other structures are omitted in FIG. 10. A layer of the OLED close to the base substrate as the first electrode, and a layer of the OLED away from the base substrate as the second electrode are illustrated as an example, but are not limited thereto.

In the above description, the surface of the planarization layer away from the base substrate having a concave shape is illustrated as an example.

Furthermore, there is provided a display device, including the OLED display panel described in the foregoing sections.

For example, the display device can be a display such as an OLED display, and any products or components having display function and including the OLED display, such as a television set, a digital camera, a cell phone, a watch, a tablet, a laptop, a navigator, etc..

The following statements should be noted:
(1) Unless otherwise defined, the same reference numeral represents the same meaning in the embodiments of the disclosure and accompanying drawings.
(2) The accompanying drawings involve only the structure(s) in connection with the embodiment(s) of the present disclosure, and other structure(s) can be referred to common design(s).
(3) For the purpose of clarity only, in accompanying drawings for illustrating the embodiment(s) of the present disclosure, the thickness and size of a layer or a structure may be enlarged. However, it should understood that, in the case in which a component or element such as a layer, film, area, substrate or the like is referred to be "on" or "under" another component or element, it may be directly on or under the another component or element or a component or element is interposed therebetween.
(4) In case of no conflict, features in one embodiment or in different embodiments can be combined.

What are described above is the embodiments of the disclosure only and not limitative to the scope of the disclosure; any of those skilled in related arts can easily conceive variations and substitutions in the technical scopes disclosed by the disclosure, which should be encompassed in protection scopes of the disclosure. Therefore, the scopes of the disclosure should be defined in the appended claims.

## Claims

1. An organic light-emitting diode, OLED, display panel, comprising a curved part (301) and a non-curved part (302), the curved part (301) comprising a plurality of organic light-emitting diodes, OLEDs, (234),
wherein each of the OLEDs (234) comprises a light adjusting surface (0201) configured to be capable of guiding light generated from the OLED (234) to exit towards the non-curved part (302);
wherein each of the OLEDs (234) comprises a plurality of layers (102, 103, 104) disposed on a base substrate (101), the plurality of layers comprise a luminescent layer (1030), the luminescent layer (1030) or a layer (1033, 1034, 104) formed after the luminescent layer (1030) has a first curved surface (201), and the light adjusting surface (0201) comprises the first curved surface (201);
**characterized in that,** on the curved part (301), a curve direction of the first curved surface (201) is the same as that of the base substrate (101) and a curvature of the first curved surface (201) is larger than that of the base substrate (101), and a light-emitting direction of the OLED (234) is opposite to the curve direction of the first curved surface (201).

2. The OLED display panel according to claim 1, wherein a light-emitting angle of the OLED (234) is larger than 90°.

3. The OLED display panel according to any one of claims 1 and 2, wherein the curved part (301) is at least a portion of the OLED display panel close to an edge of the OLED display panel.

4. The OLED display panel according to any one of claims 1 to 3, each of the layers (102, 103, 104) of the OLED (234) has the first curved surface (201).

5. The OLED display panel according to claim 1, further comprising a planarization layer (105) disposed between the base substrate (101) and a layer (102) of the OLED (234) close to the base substrate (101), wherein the layer (102) of the OLED (234) close to the base substrate (101) is in contact with the planarization layer (105), a surface of the planarization layer (105) away from the base substrate (101) has a second curved surface (202), and the second curved surface (202) and the first curved surface (201) have a same curve direction and a same curvature.

6. A display device, comprising the OLED display panel of any one of claims 1 to 5.

7. A manufacturing method of an OLED display panel, comprising:
forming a first layer (102) of an OLED (234) on a part of a base substrate (101) of the OLED display panel to be bent, a surface of the first layer (102) away from the base substrate (101) having a curved surface;
forming a subsequent film layer (103, 104) of the OLED (234) on the first layer, the subsequent film layer (103, 104) having the curved surface and comprising a luminescent layer (1030); and
bending the OLED display panel to form a curved part (301), the OLED (234) on the curved part (301) comprising a light adjusting surface (0201), and the light adjusting surface (0201) being configured to be capable of guiding light generated from the OLED (234) to exit towards a non-curved part (302), on the curved part (301), the luminescent layer (1030) has a first curved surface (201),
**characterized in that,** on the curved part (301), a curve direction of the first curved surface (201) is same as that of the base substrate (101) and a curvature of the first curved surface (201) is larger than that of the base substrate (101) , and a light-emitting direction of the OLED (234) is opposite to the curve direction of the first curved surface (201).

8. The manufacturing method of the OLED display device according to claim 7, wherein a light-emitting angle of the OLED (234) is larger than 90°.

9. The manufacturing method of the OLED display device according to claim 8, wherein, at least a portion of the OLED display device close to an edge of the OLED display device is bent to form the curved part (301).

10. The manufacturing method of the OLED display device according to any one of claims 7 to 9, further comprising forming a planarization layer (105) between the base substrate (101) and a layer (102) of the OLED (234) close to the base substrate (101), wherein the layer (102) of the OLED (234) close to the base substrate (101) is in contact with the planarization layer (105), a surface of the planarization layer (105) away from the base substrate (101) has a second curved surface (202), and the second curved surface (202) and the first curved surface (201) have a same curve direction and a same curvature; preferably, a multi-tone mask plate is adopted to form the planarization layer (105) having the second curved surface (202).

## Patentansprüche

1. Anzeige-Panel mit organischen lichtemittierenden Dioden. OLED, mit einem gekrümmten Teil (301) und einem nicht gekrümmten Teil (302), wobei der gekrümmte Teil (301) eine Vielzahl von organischen lichtemittierenden Dioden, OLEDs. (234) aufweist.
wobei jede der OLEDs (234) eine Lichtcinstellobcrnäche (0201) aufweist, die konfiguriert ist, von der OLED (234) erzeugtes Licht zum Austritt in Richtung des nicht gekrümmten Teils (302) leiten zu können;
wobei jede der OLEDs (234) eine Vielzahl von Schichten (102, 103, 104) aufweist, die auf einem Basis-Substrat (101) angeordnet sind, wobei die Vielzahl von Schichten eine Lumineszenzschicht (1030) aufweist, wobei die Lumineszenzschicht (1030) oder eine Schicht (1033, 1034, 104), die nach der Lumineszenzschicht (1030) gebildet ist. eine erste gekrümmte Oberfläche (201) aufweist, und wobei die Lichteinstelloberfläche (0201) die erste gekrümmte Oberfläche (201) aufweist;
**dadurch gekennzeichnet, dass** auf dem gekrümmten Teil (301) eine Krümmungsrichtung der ersten gekrümmten Oberfläche (201) die gleiche ist wie die des Basis-Substrats (101) und eine Krümmung der ersten gekrümmten Oberfläche (201) größer ist als die des Basis-Substrats (101), und eine Lichtemissionsrichtung der OLED (234) entgegengesetzt zu der Krümmungsrichtung der ersten gekrümmten Oberfläche (201) ist.

2. OLED-Anzeige-Panel nach Anspruch 1, wobei ein Lichtemissionswinkel der OLED (234) größer als 90° ist.

3. OLED-Anzeige-Panel nach einem der Ansprüche 1 und 2. wobei der gekrümmte Teil (301) mindestens ein Teil des OLED Anzeige-Panels in der Nähe einer Kante des OLED Anzeige-Panels ist.

4. OLED-Anzeige-Panel nach einem der Ansprüche 1 bis 3. wobei jede der Schichten (102, 103, 104) der OLED (234) die erste gekrümmte Oberfläche (201) aufweist.

5. OLED-Anzeige-Panel nach Anspruch 1. ferner mit einer Planarisierungsschicht (105), die zwischen dem Basis-Substrat (101) und einer Schicht (102) der OLED (234) nahe dem Basis-Substrat (101) angeordnet ist, wobei die Schicht (102) der OLED (234) nahe dem Basis-Substrat (101) in Kontakt mit der Planarisierungsschicht (105) ist, eine von dem Basis-Substrat (101) entfernte Oberfläche der Planarisierungsschicht (105) eine zweite gekrümmte Oberfläche (202) aufweist, und die zweite gekrümmte Oberfläche (202) und die erste gekrümmte Oberfläche (201) eine gleiche Krümmungsrichtung und eine gleiche Krümmung aufweisen.

6. Anzeigevorrichtung, mit dem OLED-Anzeige-Panel nach einem der Ansprüche 1 bis 5.

7. Verfahren zur Herstellung eines OLED-Anzeige-Panel, mit:
Bilden einer ersten Schicht (102) einer OLED (234) auf einem Teil eines Basis-Substrats (101) des zu biegende OLED Anzeige-Panels, wobei eine Oberfläche der ersten Schicht (102) weg von dem Basis-Substrat (101) eine gekrümmte Oberfläche aufweist:
Bilden einer nachfolgenden Dünnschicht (103. 104) der OLED (234) auf der ersten Schicht, wobei die nachfolgende Dünnschicht (103. 104) die gekrümmte Oberfläche aufweist und eine Lumineszenzschicht (1030) aufweist: und
Biegen des OLED-Anzeige-Panels, um einen gekrümmten Teil (301) zu bilden. wobei die OLED (234) auf dem gekrümmten Teil (301) eine Lichteinstelloberfläche (0201) aufweist und die Lichteinstelloberfläche (0201) konfiguriert ist, von der OLED (234) erzeugtes Licht leiten zu können, dass es in Richtung eines nicht gekrümmten Teils (302) austritt, wobei die Lumineszenzschicht (1030) auf dem gekrümmten Teil (301) eine erste gekrümmte Oberfläche (201) aufweist.
**dadurch gekennzeichnet, dass** auf dem gekrümmten Teil (301) eine Krümmungsrichtung der ersten gekrümmten Oberfläche (201) die gleiche ist wie die des Basis-Substrats (101) und eine Krümmung der ersten gekrümmten Oberfläche (201) größer ist als die des Basis-Substrats (101), und eine Lichtemissionsrichtung der OLED (234) entgegengesetzt zur Krümmungsrichtung der ersten gekrümmten Oberfläche (201) ist.

8. Herstellungsverfahren der OLED-Anzeigevorrichtung nach Anspruch 7. wobei ein Lichtemissionswinkel der OLED (234) größer als 90° ist.

9. Herstellungsverfahren der OLED-Anzeigevorrichtung nach Anspruch 8. wobei mindestens ein Teil der OLED-Anzeigevorrichtung nahe einer Kante der OLED-Anzeigevorrichtung gebogen wird, um den gekrümmten Teil (301) zu bilden.

10. Herstellungsverfahren der OLED-Anzeigevorrichtung nach einem der Ansprüche 7 bis 9 ferner mit Bilden einer Planarisierungsschicht (105) zwischen dem Basis-Substrat (101) und einer Schicht (102) der OLED (234) nahe dem Basis-Substrat (101), wobei die Schicht (102) der OLED (234) nahe dem Basis-Substrat (101) in Kontakt mit der Planarisierungsschicht (105) steht, eine Oberfläche der Planarisierungsschicht (105) weg von dem Basis-Substrat (101) eine zweite gekrümmte Oberfläche (202) aufweist und die zweite gekrümmte Oberfläche (202) und die erste gekrümmte Oberfläche (201) eine gleiche Krümmungsrichtung und eine gleiche Krümmung aufweisen; wobei vorzugsweise eine mehrfarbige Maskenplatte verwendet wird, um die Planarisierungsschicht (105) mit der zweiten gekrümmten Oberfläche (202) zu bilden.

## Revendications

1. Panneau d'affichage à diodes électroluminescentes organiques, OLED, comprenant une partie incurvée (301) et une partie non incurvée (302), la partie incurvée (301) comprenant une pluralité de diodes électroluminescentes organiques, OLED, (234),
dans lequel chacune des OLED (234) comprend une surface de réglage de lumière (0201) configurée pour pouvoir guider la lumière générée depuis l'OLED (234) pour qu'elle sorte en direction de la partie non incurvée (302) ; et
dans lequel chacune des OLED (234) comprend une pluralité de couches (102, 103, 104) disposées sur un substrat de base (101), la pluralité de couches comprend une couche luminescente (1030), la couche luminescente (1030) ou une couche (1033, 1034, 104) qui est formée après la couche luminescente (1030) comporte une première surface incurvée (201), et la surface de réglage de lumière (0201) comprend la première surface incurvée (201) ;
**caractérisé en ce que**, sur la partie incurvée (301), une direction de courbure de la première surface incurvée (201) est la même que celle du substrat de base (101) et une courbure de la première surface incurvée (201) est plus importante que celle du substrat de base (101), et une direction d'émission de lumière de l'OLED (234) est opposée à la direction de courbure de la première surface incurvée (201).

2. Panneau d'affichage à OLED selon la revendication 1, dans lequel un angle d'émission de lumière de l'OLED (234) est supérieur à 90°.

3. Panneau d'affichage à OLED selon l'une quelconque des revendications 1 et 2, dans lequel la partie incurvée (301) est au moins une section du panneau d'affichage à OLED à proximité d'un bord du panneau d'affichage à OLED.

4. Panneau d'affichage à OLED selon l'une quelconque des revendications 1 à 3, chacune des couches (102, 103, 104) de l'OLED (234) comporte la première surface incurvée (201).

5. Panneau d'affichage à OLED selon la revendication 1, comprenant en outre une couche de planarisation (105) disposée entre le substrat de base (101) et une couche (102) de l'OLED (234) à proximité du substrat de base (101), dans lequel la couche (102) de l'OLED (234) à proximité du substrat de base (101) est en contact avec la couche de planarisation (105), une surface de la couche de planarisation (105) à distance du substrat de base (101) comporte une seconde surface incurvée (202), et la seconde surface incurvée (202) et la première surface incurvée (201) présentent une même direction de courbure et une même courbure.

6. Dispositif d'affichage, comprenant le panneau d'affichage à OLED selon l'une quelconque des revendications 1 à 5.

7. Procédé de fabrication d'un panneau d'affichage à OLED, comprenant :
la formation d'une première couche (102) d'une OLED (234) sur une partie d'un substrat de base (101) du panneau d'affichage à OLED à cambrer, une surface de la première couche (102) à distance du substrat de base (101) comportant une surface incurvée ;
la formation d'une couche de film subséquente (103, 104) de l'OLED (234) sur la première couche, la couche de film subséquente (103, 104) comportant la surface incurvée et comprenant une couche luminescente (1030) ; et
la cambrage du panneau d'affichage à OLED pour former une partie incurvée (301), l'OLED (234) sur la partie incurvée (301) comprenant une surface de réglage de lumière (0201), et la surface de réglage de lumière (0201) étant configurée pour pouvoir guider la lumière générée depuis l'OLED (234) pour qu'elle sorte en direction d'une partie non incurvée (302), sur la partie incurvée (301), la couche luminescente (1030) comporte une première surface incurvée (201),
**caractérisé en ce que**, sur la partie incurvée (301), une direction de courbure de la première surface incurvée (201) est la même que celle du substrat de base (101) et une courbure de la première surface incurvée (201) est plus importante que celle du substrat de base (101), et une direction d'émission de lumière de l'OLED (234) est opposée à la direction de courbure de la première surface incurvée (201).

8. Procédé de fabrication du dispositif d'affichage à OLED selon la revendication 7, dans lequel un angle d'émission de lumière de l'OLED (234) est supérieur à 90°.

9. Procédé de fabrication du dispositif d'affichage à OLED selon la revendication 8, dans lequel au moins une section du dispositif d'affichage à OLED à proximité d'un bord du dispositif d'affichage à OLED est cambrée pour former la partie incurvée (301).

10. Procédé de fabrication du dispositif d'affichage à OLED selon l'une quelconque des revendications 7 à 9, comprenant en outre la formation d'une couche de planarisation (105) entre le substrat de base (101) et une couche (102) de l'OLED (234) à proximité du substrat de base (101), dans lequel la couche (102) de l'OLED (234) à proximité du substrat de base (101) est en contact avec la couche de planarisation (105), une surface de la couche de planarisation (105) à distance du substrat de base (101) comporte une seconde surface incurvée (202), et la seconde surface incurvée (202) et la première surface incurvée (201) présentent une même direction de courbure et une même courbure ; de préférence, une plaque de masque à multiples teintes est adoptée pour former la couche de planarisation (105) qui comporte la seconde surface incurvée (202).
